# EUROPÄISCHE PATENTSCHRIFT

(11) **EP 3 771 950 B1**
(45) Veröffentlichungstag und Bekanntmachung des Hinweises auf die Patenterteilung: **07.09.2022**
(21) Anmeldenummer: 20188580.3
(22) Anmeldetag: 30.07.2020
(51) Int. Cl.: G05B 19/042

(54) **STEUER- UND AUSWERTEEINHEIT FÜR EIN SIGNALÜBERTRAGUNGSSYSTEM**
CONTROL AND MONITORING DEVICE FOR A SIGNAL TRANSMISSION SYSTEM
DISPOSITIF DE COMMANDE ET DE SURVEILLANCE POUR UN SYSTÈME DE TRANSMISSION DE SIGNAL

(30) Priorität: 02.08.2019 DE 102019120918
(43) Veröffentlichungstag der Anmeldung: 03.02.2021
(73) Patentinhaber: Gesellschaft für Gerätebau mbH, 44143 Dortmund (DE)
(72) Erfinder: Hübner, Hans-Jörg, 44141 Dortmund (DE); Böttger, Frank, 44339 Dortmund (DE); Erik, Buck, 44225 Dortmund (DE)
(74) Vertreter: Gesthuysen Patentanwälte

(56) Entgegenhaltungen:
- WO-A1-2015/128336
- DE-A1-102008 043 199
- DE-A1-102015 105 887

## Beschreibung

Die Erfindung betrifft eine Steuer- und Auswerteeinheit für ein Signalübertragungssystem und ein Signalübertragungssystem mit mindestens einem Signalwertgeber, einer Leitung und einer Steuer- und Auswerteeinheit, wobei der Signalwertgeber eine Elektronikeinheit und eine Stromquelle aufweist und einen eingeprägten Strom im Bereich zwischen einem vorbestimmten ersten Wert und einem vorbestimmten zweiten Wert, insbesondere zwischen 4 und 20 mA, in die Leitung einspeist. Die Steuer- und Auswerteeinheit weist eine Last und einen Mikroprozessor auf und erfasst die über der Last abfallende Spannung.

Die DE 10 2008 043 199 A1 offenbart ein autarkes Feldgerät, bei dem ein Messumformer mit einem I/O-Modul verbunden ist, wobei das I/O-Modul als 4-20 mA/Hart I/O-Modul ausgestaltet ist. Das I/O-Modul weist eine steuerbare Energiequelle auf, über die das Feldgerät mit Energie versorgt wird. Darüber hinaus weist das I/O-Modul eine Steuereinheit, eine Strommesseinheit und mindestens zwei in Reihe geschaltete Widerstände auf, die je nach Betriebsphase des Feldgeräts zur Optimierung der Energieversorgung zugeschaltet oder überbrückt werden. Außerdem weist das Feldgerät eine Funkeinheit auf, über die es mit einer übergeordneten Steuereinheit kommunizieren kann.

Aus der WO 2015/128336 A1 ist eine Eingangsschalteinheit bekannt, bei der mittels eines Schalters und eines überbrückbaren Widerstandes einstellbar ist, ob der Eingang als analoger Spannungseingang oder als analoger Stromeingang für einen Messstrom fungiert.

Die DE 10 2015 105 887 A1 offenbart eine HART-Kommunikationsbox mit einer Elektronik und einem Kommunikationswiderstand, wobei der Kommunikationswiderstand nur dann in eine Stromschleife zugeschaltet wird, wenn ein vorheriges Testspannungssignal ein Referenzsignal überschreitet.

Signalübertragungssysteme werden insbesondere in der Prozesssteuerungs-und Anlagentechnik zur Übertragung von Prozesswerten von verschiedenen Orten zu einem meist zentralen Überwachungs- und Kontrollort eingesetzt. Hierzu sind vor Ort, beispielsweise an entsprechenden Maschinen oder Anlagen oder in deren Umgebung entsprechende Signalwertgeber positioniert. Bei dem Signalwertgeber kann es sich beispielsweise um einen Messwertgeber handeln, der dann noch mindestens einen Sensor zu Erfassung eines Messwerts aufweist. Daneben kann es sich bei dem Signalwertgeber aber beispielsweise auch um einen Datensammler, eine Anzeigeeinheit oder einen Aktor handeln, die ebenfalls einen Wert über die Leitung zur Steuer- und Auswerteeinheit übertragen können. Nachfolgend wird meistens von einem Messwertgeber als Signalwertgeber gesprochen, ohne dass die Erfindung darauf beschränkt sein soll.

Ein Messwertgeber erfasst mit Hilfe eines entsprechenden Sensors den jeweiligen Messwert, der dann ggf. nach einer entsprechenden Verstärkung und Normierung über eine Leitung an die entfernt angeordnete Steuer- und Auswerteeinheit übertragen wird. Bei dem zu erfassenden Messwert kann es sich beispielsweise um eine Temperatur, einen Druck, eine Gaskonzentration oder eine Mediumsgeschwindigkeit handeln. Grundsätzlich kann einem Messwertgeber genau einer Steuer- und Auswerteeinheit zugeordnet sein. In der Regel sind die Steuer- und Auswerteeinheiten jedoch so ausgebildet, dass an diese mehrere, beispielsweise vier, acht, sechzehn oder auch mehr Messwertgeber bzw. Signalwertgeber angeschlossen werden können, die über die Steuer- und Auswerteeinheit konfiguriert und überwacht werden können. Dadurch können an unterschiedlichen, teilweise schwer zugänglichen oder weit voneinander entfernten Orten ermittelte Messwerte zentral an einem Ort überwacht und angezeigt werden.

Bei bestehenden Anlagen sind häufig analog übertragende Messwertgeber im Einsatz, die zumeist in Sternverkabelungen mit der Steuer- und Auswerteeinheit verbunden sind. Hierbei hat sich seit Jahren in der Praxis die Messwertübertragung mittels eines eingeprägten Gleichstroms im Bereich von 4 bis 20 mA de facto als eine Art Standard für die Übertragung analoger Messwerte vom Messwertgeber über eine Leitung zu einer Steuer- und Auswerteeinheit etabliert. Dadurch kann ein analoger Messwert kontinuierlich übertragen werden, so dass auch bei einer Mehrzahl von an einer Steuer- und Auswerteeinheit angeschlossenen Messwertgebern stets der aktuelle Messwert eines jeden einzelnen Messwertgebers an der Steuer- und Auswerteeinheit abrufbar bzw. anzeigbar ist.

Die Verbindung der einzelnen Messwertgeber mit der Steuer- und Auswerteeinheit erfolgt dabei in der Regel mit einer zweiadrigen oder dreiadrigen Leitung. Die Verwendung von dreiadrigen Leitungen hat dabei den Vorteil, dass zwei Adern zur Energieversorgung des Messwertgebers genutzt werden können, während über die dritte Ader der dem Messwert entsprechende eingeprägte Strom übertragen wird. Aufgrund der Normierung entspricht der minimale Messwert eines vorgegebenen Messbereichs einem über die Leitung übertragenen Strom von 4 mA und der maximale Messwert einem Strom von 20 mA. Dadurch sind sowohl eine Überwachung auf Leitungsbruch (Strom = 0 mA) als auch eine Messbereichsüberschreitung (Strom > 20 mA) möglich. In beiden Fällen weiß die Auswerteelektronik der Steuer- und Auswerteeinheit, dass der ankommende Stromwert nicht als tatsächlich vorliegender Messwert ausgewertet und angezeigt werden darf.

Auch wenn sich diese Messwertübertragung mittels eines eingeprägten Stromes aufgrund ihrer Zuverlässigkeit und ihrer sehr geringen Beeinflussbarkeit durch elektromagnetische Störungen seit vielen Jahren sehr bewährt hat, so ist sie jedoch auch mit dem Nachteil verbunden, dass neben dem eigentlichen Messwert und den beiden zuvor genannten Fehlerzuständen quasi keine weiteren Informationen übertragen werden können. Darüber hinaus ist die Übertragung der Informationen nur in eine Richtung, nämlich vom Messwertgeber zur Steuer- und Auswerteeinheit möglich. Für eine gesicherte Übertragung sind außerdem häufig zusätzliche Fehlererkennungen von Komponenten bzw. deren Verbindungen wünschenswert.

Beide Nachteile lassen sich dadurch beheben, dass anstelle von analog übertragenden Messwertgebern digital übertragende Messwertgeber eingesetzt werden, die in der Regel nicht über eine zwei- bzw. dreiadrige Sternverkabelung, sondern über eine vieradrige Busverkabelung mittels einzelner Stränge oder einem Ring mit der Steuer- und Auswerteeinheit verbunden sind. Diese Lösung kann zwar ohne Probleme beim Aufbau neuer Anlagen umgesetzt werden, bei bestehenden Anlagen ist jedoch ein Austausch sämtlicher Komponenten, d. h. aller Messwertgeber, Steuer- und Auswerteeinheiten und im Besonderen aller Leitungen erforderlich, was nicht nur mit einem sehr hohen Kostenaufwand verbunden ist, sondern in der Regel auch eine längere Unterbrechung der laufenden Prozesse erforderlich macht. Aus diesem Grunde kommt bei bestehenden Anlagen ein vollständiger Austausch des Signalübertragungssystems in der Regel nicht in Betracht.

Der vorliegenden Erfindung liegt daher die Aufgabe zugrunde, eine eingangs beschriebene Steuer- und Auswerteeinheit und ein Signalübertragungssystem derart weiterzuentwickeln, dass zusätzliche Informationen über das Signalübertragungssystem bzw. dessen Komponenten möglichst einfach erfasst und übermittelt werden können. Der Austausch einer Komponente, beispielsweise einer Steuer- und Auswerteeinheit soll dabei nicht zwingend auch den Austausch anderer Komponenten, beispielsweise einzelner Signalwertgeber oder einzelner Leitungen, erforderlich machen.

Diese Aufgabe ist bei der Steuer- und Auswerteeinheit mit den Merkmalen des Patentanspruchs 1 und bei dem Signalübertragungssystem mit den Merkmalen des Patentanspruchs 4 gelöst.

Die erfindungsgemäße Steuer- und Auswerteeinheit ist dadurch gekennzeichnet, dass sie neben einer mit einem Signaleingang verbundenen Last und einem Mikroprozessor mindestens ein elektrisches Bauteil und einen Schalter aufweist, wobei das elektrische Bauteil der Last in Reihe geschaltet ist und mittels des Schalters wahlweise überbrückt werden kann. Der Mikroprozessor ermittelt dabei die über der Last abfallende Spannung sowohl für den Fall, dass das elektrische Bauteil der Last in Reihe geschaltet ist, als auch für den Fall, dass das elektrische Bauteil überbrückt ist. Ergibt ein Vergleich der beiden Spannungen, dass der Unterschied zwischen den beiden Spannungen einen Schwellwert überschreitet, so wird von der Steuer- und Auswerteeinheit eine Fehler erkannt, der dann entsprechend ausgegeben werden kann. Eine derartige Fehlermeldung kann dabei auf optischer, akustischer und/oder elektrischer Art und Weise erfolgen.

Gemäß einer bevorzugten Ausgestaltung der Steuer- und Auswerteeinheit weist diese außerdem einen Komparator und vorzugsweise auch einen Schmitt-Trigger auf, wobei ein Eingang des Komparators mit dem Verbindungspunkt zwischen der Last und dem elektrischen Bauteil und der Schmitt-Trigger mit dem Ausgang des Komparators verbunden ist. Vorzugsweise ist darüber hinaus der Mikroprozessor mit dem Ausgang des Schmitt-Triggers verbunden.

Auch bei dem erfindungsgemäßen Signalübertragungssystem ist der Last in der Steuer- und Auswerteeinheit mindestens ein elektrisches Bauteil in Reihe geschaltet ist, an dem ein Gleichspannungsabfall auftritt, wenn das elektrische Bauteil von einem Strom durchflossen wird. Der Mikroprozessor ermittelt dabei die über der Last abfallende Spannung bei beiden Zuständen des Schalters, vergleicht die Spannungen miteinander und erkennt bei Über- oder Unterschreitung eines Schwellwertes einen Fehler, wodurch die Ausgabe einer entsprechenden Fehlermeldung initiiert werden kann.

Der Mikroprozessor der Steuer- und Auswerteeinheit ermittelt somit sowohl die Spannung U1, die über der Last abfällt, wenn das elektrische Bauteil überbrückt ist, als auch die Spannung U2, die über der Last abfällt, wenn das elektrische Bauteil der Last in Reihe geschaltet ist. Anstelle der jeweiligen Spannung, die über der Last abfällt, kann auch der durch die Last fließende Strom gemessen werden. In beiden Fällen ist eine Ermittlung der über der Last abfallenden Spannung durch den Mikroprozessor und somit auch ein entsprechender Vergleich der beiden Spannungen möglich.

Mit dem Begriff elektrisches Bauteil wird ganz allgemein ein Bauteil bezeichnet, an dem ein Gleichspannungsabfall auftritt, wenn das elektrische Bauteil von einem Strom durchflossen wird. Bei dem Bauteil kann es sich nicht nur um ein einzelnes Bauelement, sondern auch um mehrere einzelne Bauelemente handeln, die miteinander verschaltet sind, beispielsweise zueinander elektrisch in Reihe geschaltet sind. Im einfachsten Fall kann es sich bei dem elektrischen Bauteil um einen Widerstand handeln. Als elektrisches Bauteil kann beispielsweise auch eine Diode oder eine Reihenschaltung aus einem Widerstand und einer Diode vorgesehen sein.

Da bei dem Signalübertragungssystem vom Messwertgeber ein eingeprägter Strom in die Leitung eingespeist wird, wird durch die Stromquelle des Messwertgebers im Normalfall auch dann der Strom konstant gehalten, wenn sich durch die Zuschaltung des elektrischen Bauteils in der Steuer- und Auswerteeinheit der durch die Last und das elektrische Bauteil bestimmte Eingangswiderstand an der Steuer- und Auswerteeinheit und damit das Lastverhältnis auf der Leitung ändert. Die durch die Zuschaltung des elektrischen Bauteils vorgenommene aktive Laständerung wird somit im Normalfall durch die Stromquelle im Messwertgeber ausgeregelt, so dass der durch die Last in der Steuer- und Auswerteeinheit fließende Strom unabhängig davon ist, ob das elektrische Bauteil der Last in Reihe geschaltet ist oder nicht. Die Spannung U1, die über der Last abfällt, wenn das elektrische Bauteil überbrückt ist, sollte im Wesentlichen der Spannung U2 entsprechen, die über der Last abfällt, wenn das elektrische Bauteil der Last in Reihe geschaltet ist. Ist dies nicht der Fall bzw. überschreitet der Unterschied zwischen den beiden Spannungen einen vorgegebenen Schwellwert, so wird dies vom Mikroprozessor als ein Fehler erkannt und eine entsprechende Fehlermeldung ausgegeben. Ein Fehler kann beispielsweise darin bestehen, dass der Messwertgeber selber defekt ist oder eine Fehlverdrahtung vorliegt.

Die zuvor beschriebene erfindungsgemäße Maßnahme, nämlich in der Steuer-und Auswerteeinheit ein elektrisches Bauteil derart anzuordnen, dass dieses mittels eines Schalters in Reihe zur Last geschaltet oder überbrückt werden kann, stellt eine wirkungsvolle, aber sehr einfache schaltungstechnische Maßnahme dar, um einen Fehler im Signalübertragungssystem festzustellen. Diese Maßnahme erfordert dabei insbesondere auch nicht, dass bestehende, analog übertragende Messwertgeber ausgetauscht und durch digital übertragende Messwertgeber ersetzt werden müssen. Ebenso wenig müssen bereits verlegte Leitungen zwischen den einzelnen Messwertgebern und der Steuer- und Auswerteeinheit ausgetauscht werden.

Wird die Last der Steuer- und Auswerteeinheit als Bürde bezeichnet, so wird durch die Anordnung des elektrischen Bauteils und des Schalters auf einfache Art und Weise eine Bürdenumschaltung realisiert. Der Widerstandswert der Last und der Widerstandswert des elektrischen Bauteils sind dabei vorzugsweise in der selben Größenordnung. Insbesondere kann der Widerstandswert der Last im Wesentlichen dem Widerstandswert eines als elektrisches Bauteil eingesetzten weiteren Widerstands entsprechen oder nur leicht von diesem abweichen.

Gemäß einer vorteilhaften Ausgestaltung des erfindungsgemäßen Signalübertragungssystems erfolgt das Schalten des Schalters in der Steuer- und Auswerteeinheit getaktet, wobei der Takt einen vorgegebenen seriellen Datenstrom repräsentiert bzw. diesem entspricht. Die zuvor beschriebene Bürdenumschaltung erfolgt dann getaktet entsprechend einem seriellen Datenstrom, was dazu genutzt werden kann, Daten von der Steuer- und Auswerteeinheit zum Signalwertgeber zu übertragen. Dem in die Leitung eingespeisten konstanten Strom wird durch die getaktete Umschaltung des Schalters eine Spannungsänderung überlagert, die bei entsprechender Ausgestaltung des Signalwertgebers von diesem detektiert werden kann. Die Steuerung des Schalters, mit dem das elektrische Bauteil der Last in Reihe geschaltet oder überbrückt wird, erfolgt vorzugsweise durch den in der Steuer- und Auswerteeinheit angeordneten Mikroprozessor.

Bei einer weiteren besonders bevorzugten Ausgestaltung des erfindungsgemäßen Signalübertragungssystems ist der Signalwertgeber so ausgebildet, dass er den von der Steuer- und Auswerteeinheit über die Leitung übertragenen, den konstanten Strom überlagerten seriellen Datenstrom detektieren und auswerten kann. Hierzu weist der Signalwertgeber einen Komparator auf, wobei ein Eingang des Komparators mit der Leitung verbunden ist. Dadurch kann auf einfache Art und Weise aus der an der Leitung anstehenden Spannungsänderung, die durch das getaktete Schalten des Schalters in der Steuer- und Auswerteeinheit verursacht wird, ein serieller Datenstrom erzeugt werden, der dem seriellen Datenstrom entspricht, mit dem der Schalter des Schalters in der Steuer- und Auswerteeinheit getaktet ist. Dem Komparator kann ein Schmitt-Trigger nachgeschaltet sein, der dann mit dem Ausgang des Komparators verbunden ist und eine Hysterese erzeugt, um aus dem analogen Eingangssignal ein eindeutiges, binäres Signal zu erzeugen.

Durch die zuvor beschriebene Taktung des Schalters in der Steuer- und Auswerteeinheit und die zuvor beschriebene Ausgestaltung des Messwertgebers mit einem Komparator ist somit die Möglichkeit geschaffen worden, Informationen in Form von seriellen Daten von der Steuer- und Auswerteeinheit zum Messwertgeber zu übertragen und diese seriellen Daten vom Messwertgeber zu empfangen, ohne dass dabei eine bereits verlegte Leitung, beispielsweise eine zweiadrige oder dreiadrige Leitung durch eine besondere Busleitung ersetzt werden muss.

Bei der zuvor beschriebenen Ausgestaltung des Messwertgebers weist dieser vorzugsweise einen Mikroprozessor auf, der mit dem Ausgang des Komparators bzw. mit dem Ausgang des Schmitt-Triggers verbunden ist, wenn dem Komparator ein Schmitt-Trigger nachgeschaltet ist. Mit Hilfe des Mikroprozessors kann der erfasste serielle Datenstrom auf Plausibilität überprüft und somit Übertragungsfehler erkannt werden. Außerdem kann in dem Mikroprozessor eine Auswertung des empfangenen Datenstroms erfolgen.

Gemäß einer weiteren, besonders bevorzugten Ausgestaltung des Signalübertragungssystems ist der Signalwertgeber zusätzlich so ausgestaltet, dass auch vom Signalwertgeber neben dem eigentlichen Messwert serielle Daten über die Leitung zur Steuer- und Auswerteeinheit übertragen werden können. Hierzu weist der Signalwertgeber vorzugsweise einen Mischer auf, in dem zu übertragenden Messwert ein getaktetes Signal überlagert wird, das den seriellen Datenstrom repräsentiert. Von dem Signalwertgeber wird dann ein modulierter Strom in die Leitung eingespeist, der in der Amplitude moduliert ist. Die Trägeramplitude kann weiterhin proportional zu dem zu übertragenden Messwert sein, also vorzugsweise zwischen 4 und 20 mA liegen. Durch die Überlagerung des getakteten Signals wird diese im Takt des seriellen Datenstroms geringfügig geändert, so dass durch die Amplitudenmodulation die Übermittlung des Messwertes über die Leitung nur während der Datenübertragung beeinträchtigt wird.

Zur Erfassung und Auswertung der vom Signalwertgeber über die Leitung übertragener Daten weist die Steuer- und Auswerteeinheit gemäß einer weiteren vorteilhaften Ausgestaltung des erfindungsgemäßen Signalübertragungssystems ebenfalls einen Komparator auf, wobei ein Eingang des Komparators mit der Leitung verbunden ist. Der eine Eingang des Komparators ist dabei insbesondere mit dem Verbindungspunkt zwischen der Last und dem elektrischen Bauteil verbunden. Durch die Verwendung eines Komparators kann wiederum auf einfache Art und Weise das auf den konstanten Strom aufmodulierte Datensignal detektiert und ausgewertet werden. Aus der im Takt des Datenstroms pulsierenden Spannung, die über der Last abfällt, kann so mit Hilfe des Komparators der vom Signalwertgeber dem Strom aufmodulierte serielle Datenstrom restauriert werden.

Dem Komparator kann dabei wiederum ein Schmitt-Trigger nachgeschaltet sein, der somit mit dem Ausgang des Komparators verbunden ist. Auch hierbei ist vorzugsweise ein Mikroprozessor mit dem Ausgang des Komparators bzw. des Schmitt-Triggers verbunden, um den ausgewerteten Datenstrom auf Plausibilität zu prüfen und somit mögliche Übertragungsfehler zu erkennen. Das zuvor beschriebene erfindungsgemäße Signalübertragungssystem ermöglicht es auf einfache und flexible Art und Weise, ein bestehendes Signalübertragungssystem zu modernisieren, wobei vorhandene Leitungen weiter genutzt werden können. In einem ersten Schritt kann eine bestehende Steuer- und Auswerteeinheit ersetzt und entsprechend der Erfindung modifiziert werden. An diese können weiterhin die bereits vorhandenen, analog übertragenden Messwertgeber oder alternativ und sukzessive neue Messwertgeber, die zusätzliche Daten übermitteln und empfangen können, angeschlossen werden.

Der Messwertgeber kann neben mindestens einem Sensor, einer Elektronikeinheit und einer Stromquelle zusätzlich noch einen Komparator aufweisen, wobei ein Eingang des Komparators mit dem Ausgangsanschluss, an dem der eingeprägte Strom zur Verfügung steht, verbunden ist. Aus einer am Ausgangsanschluss anstehenden pulsierenden Spannung kann so ein serieller Datenstrom ermittelt werden.

Gemäß einer bevorzugten Ausgestaltung des Messwertgebers weist dieser einen Mischer auf, mittels dem dem vom Sensor erfassten Messwert ein getaktetes Signal überlagert wird, das einen seriellen Datenstrom repräsentiert, so dass am Ausgangsanschluss des Messwertgebers ein amplitudenmodulierter Strom zur Verfügung steht. Hierdurch können von dem Messwertgeber zusätzlich zum eigentlichen Messwert weitere Informationen über die Leitung an eine Steuer- und Auswerteeinheit übermittelt werden, so dass beispielsweise Informationen über die Restlebensdauer eines verschleißbehafteten Sensors des Messwertgebers ausgewertet werden können. Dadurch kann ein bevorstehender Defekt rechtzeitig erkannt und entsprechende Instandsetzungsmaßnahmen eingeleitet werden. Insgesamt lassen sich so Störungszeiten minimieren und damit die Betriebszeit und die Produktivität einer Anlage erhöhen.

Im Einzelnen gibt es eine Vielzahl von Möglichkeiten, das Signalübertragungssystem, den Messwertgeber und die Steuer- und Auswerteeinheit auszugestalten und weiterzubilden. Dazu wird verwiesen sowohl auf die Patentansprüche als auch auf die nachfolgende Beschreibung bevorzugter Ausführungsbeispiele in Verbindung mit der Zeichnung. In der Zeichnung zeigen
- Fig. 1: ein vereinfachtes Blockschaltbild eines Signalübertragungssystems, mit zwei Messwertgebern und einer Steuer- und Auswerteeinheit, und
- Fig. 2: ein vereinfachtes Schaltbild eines erfindungsgemäßen Signalübertragungssystems.

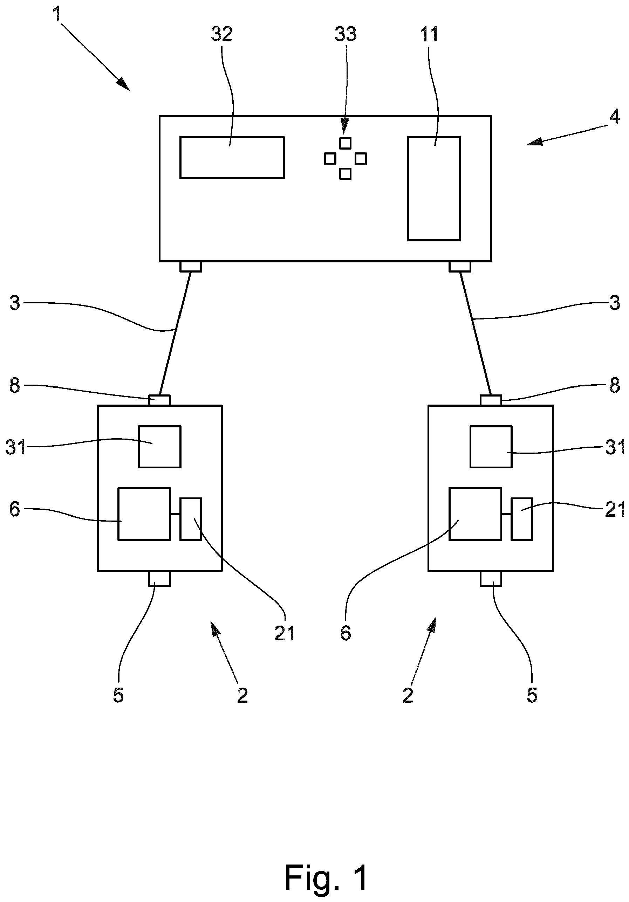

Fig. 1 zeigt in schematischer Darstellung, wie ein Signalübertragungssystem 1 aufgebaut sein kann. Dargestellt sind zwei Messwertgeber 2, die, wie eine Mehrzahl anderer, nicht dargestellter Messwertgeber jeweils über eine Leitung 3 an eine Steuer- und Auswerteeinheit 4 angeschlossen sind. Die einzelnen Messwertgeber 2 weisen jeweils mindestens einen Sensor 5 auf, die je nach Ausgestaltung unterschiedliche physikalische Größen messen können.

Handelt es sich bei dem Signalübertragungssystem 1 beispielsweise um eine Gaswarnanlage, so weisen die einzelnen Messwertgeber 2 Sensoren 5 auf, die die Konzentration von brennbaren, toxischen Gasen oder von Sauerstoff messen können. Bei einer derartigen Gaswarnanlage wird die Steuer- und Auswerteeinheit 4 häufig auch als Gaswarnzentrale bezeichnet. Die Verbindung der einzelnen Messwertgeber 2 mit der Steuer- und Auswerteeinheit 4 erfolgt dabei in der Regel über dreiadrige Leitungen 3, wobei zwei Adern der Energieversorgung der Messwertgeber 2 und die dritte Ader der Übertragung des erfassten Messwertes dient. Der vom Sensor 5 eines Messwertgebers 2 erfasste Messwert, also beispielsweise eine bestimmte Gaskonzentration, wird mit Hilfe einer im Messwertgeber 2 vorgesehenen Elektronikeinheit 6 und einer Stromquelle 7 in einen eingeprägten Gleichstrom im Bereich von 4 bis 20 mA umgewandelt, wobei in der Regel 4 mA dem Minimalwert und 20 mA dem Maximalwert eines bestimmten, einstellbaren Messbereichs entsprechen. Denkbar ist auch eine umgekehrte Zuordnung, sodass 4 mA dem Maximalwert und 20 mA dem Minimalwert eines bestimmten, einstellbaren Messbereichs entsprechen.

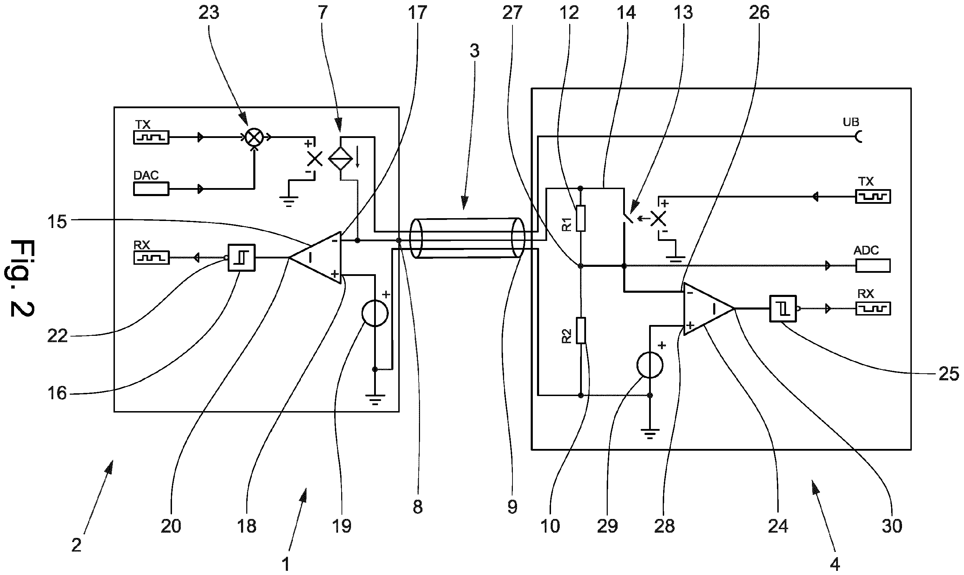

Aus dem in Fig. 2 dargestellten vereinfachten Schaltbild des Signalübertragungssystems 1 ist erkennbar, dass die Stromquelle 7 im Messwertgeber 2 über einen Ausgangsanschluss 8 mit einer Ader der Leitung 3, nämlich der zuvor genannten dritten Ader verbunden ist, über die der den Messwert repräsentierende eingeprägte Gleichstrom übertragen wird. Am anderen Ende der Leitung 3 ist diese Ader mit einem Signaleingang 9 der Streuer- und Auswerteeinheit 4 verbunden. Die Steuer- und Auswerteeinheit 4 weist eine Last 10 auf, die mit dem Signaleingang 9 derart verbunden ist, so dass der über die dritte Ader der Leitung 3 übertragene Strom durch die Last 10 fließt. Mit Hilfe eines A/D-Wandlers im Mikroprozessor 11 kann die über der Last 10 abfallende Spannung erfasst und ausgewertet werden.

Bei dem erfindungsgemäßen Signalübertragungssystem 1 bzw. der erfindungsgemäßen Steuer- und Auswerteeinheit 4 ist neben der Last 10 noch ein elektrisches Bauteil, insbesondere ein weiterer Widerstand 12 vorgesehen, der in Reihe zur Last 10 geschaltet ist, wobei er zwischen dem Signaleingang 9 und der Last 10 angeordnet ist. Außerdem ist ein Schalter 13 vorgesehen, mittels dem der weitere Widerstand 12 überbrückt werden kann. Der Schalter 13 ist dazu in einem parallel zum weiteren Widerstand 12 vorgesehenen Überbrückungszweig 14 angeordnet. Anstelle nur eines Widerstandes 12 als elektrisches Bauteil kann beispielsweise auch eine Reihenschaltung aus einem Widerstand und einer - hier nicht dargestellten Diode - der Last 10 in Reihe geschaltet sein.

Da bei dem Signalübertragungssystem 1 vom Messwertgeber 2 ein eingeprägter Strom in die Leitung 3 eingespeist wird, wird durch die Stromquelle 7 der durch die Last 10 fließende Strom konstant gehalten, unabhängig davon, ob der weitere Widerstand 12 bei geschlossenem Schalter 13 überbrückt ist, oder bei geöffnetem Schalter 13 in Reihe zur Last 10 liegt. Durch die Zuschaltung bzw. Überbrückung des weiteren Widerstands 12 erfolgt eine aktive Laständerung in der Steuer- und Auswerteeinheit 4, die im Normalfall jedoch nicht zu einer Änderung des durch die Leitung 3 und damit auch durch die Last 10 fließenden Stromes führen sollte, da die Laständerung durch die Stromquelle 7 ausgeregelt wird.

Wird nun durch den Mikroprozessor 11 der Steuer- und Auswerteeinheit 4 der durch die Last 10 fließende Strom bzw. die über der Last 10 abfallende Spannung sowohl bei geöffnetem Schalter 13 als auch bei geschlossenem Schalter 13 gemessen, so kann aus einem Vergleich der beiden Spannungen bzw. Ströme ein Fehler im Signalübertragungssystem 1 detektiert werden. Ein Fehler kann beispielsweise darin bestehen, dass der Messwertgeber 2 bzw. dessen Stromquelle 7 defekt ist oder eine Fehlverdrahtung vorliegt bzw. auf der Leitung 3 ein Defekt gegeben ist. Durch die zuvor beschriebene Maßnahme, den weiteren Widerstand 12 wahlweise zu überbrücken oder der Last 10 in Reihe zu schalten, ist mit sehr geringem schaltungstechnischen Aufwand eine Fehlererkennung in der Steuer- und Auswerteeinheit 4 möglich.

Bei dem in Fig. 2 dargestellten bevorzugten Ausführungsbeispiel des Signalübertragungssystems 1 wird der Schalter 13 nicht nur zur Durchführung der zuvor beschriebenen Fehlererkennung geöffnet bzw. geschlossen, sondern der Schalter 13 wird auch zur Übertragung von Daten von der Steuer- und Auswerteeinheit 4 zum Messwertgeber 2 genutzt. Hierzu erfolgt das Schalten des Schalters 13 getaktet, wobei der Takt einen vorgegebenen seriellen Datenstrom repräsentiert. Hierdurch wird dem in die Leitung 3 eingespeisten konstanten Strom eine Spannungsänderung überlagert, die auch im Messwertgeber 2 detektierbar ist. Der Messwertgeber 2 weist dazu einen Komparator 15 und einen Schmitt-Trigger 16 auf, wobei ein Eingang 17 des Komparators 15 mit der Leitung 3 und der andere Eingang 18 mit einem Bezugspotential 19 verbunden ist. Der Ausgang 20 des Komparators 15 ist mit dem Schmitt-Trigger 16 verbunden, so dass aus der an der Leitung 3 anstehenden Spannungsänderung, die durch das getaktete Schalten des Schalters 13 in der Steuer- und Auswerteeinheit 4 verursacht wird, ein serieller Datenstrom und somit eine von der Steuer- und Auswerteeinheit 4 ausgesandte Information vom Messwertgeber 2 empfangen werden kann. Zur Auswertung des empfangenen seriellen Datenstroms weist auch der Messwertgeber 2 einen Mikroprozessor 21 auf, der außerdem dazu verwendet werden kann, den empfangenen seriellen Datenstrom auf Plausibilität zu überprüfen. Hierzu ist der Mikroprozessor 21 mit dem Ausgang 22 des Schmitt-Triggers 16 verbunden.

Um neben dem Messwert zusätzliche Informationen auch vom Messwertgeber 2 zur Steuer- und Auswerteeinheit 4 übertragen zu können, weist der Messwertgeber 2 einen Mischer 23 auf, mittels dem dem vom Sensor 5 erfassten Messwert ein getaktetes Signal überlagert wird, das einen seriellen Datenstrom repräsentiert, so dass in die Leitung 3 ein modulierter Strom eingespeist wird. Der in die Leitung 3 eingespeiste Strom ist dann amplitudenmoduliert, wobei die Trägeramplitude durch den vom Sensor 5 gemessenen Messwert bestimmt wird, vorzugsweise also zwischen 4 und 20 mA liegt.

Die auf diese Weise zusätzlich zum eigentlichen Messwert über die Leitung 3 übertragene Information des Messwertgebers, welche beispielsweise eine Aussage über die Restlebensdauer des Sensors 5 enthalten kann, wird in der Steuer- und Auswerteeinheit 4 dadurch detektiert, dass diese einen Komparator 24 aufweist, dem vorliegend noch ein Schmitt-Trigger 25 nachgeschaltet ist. Ein Eingang 26 des Komparators 24 ist mit dem Verbindungspunkt 27 zwischen der Last 10 und dem weiteren Widerstand 12 verbunden, während der andere Eingang 28 mit einem Bezugspotential 29 verbunden ist. Der Ausgang 30 des Komparators 24 ist mit dem Schmitt-Trigger 25 verbunden, der an einen Eingang des Mikroprozessors 11 angeschlossen ist.

Durch die Verwendung eines Komparators 24 sowie die zuvor beschriebene Verschaltung kann auf einfache Art und Weise das dem konstanten Strom aufmodulierte Datensignal detektiert und ausgewertet werden. Somit kann auch auf Seiten der Steuer- und Auswerteeinheit 4 die vom Messwertgeber 2 dem eigentlichen Messwert aufmodulierte zusätzliche Information empfangen werden.

Die Fig. 1 zeigt auch eine schematische Darstellung der Messwertgeber 2 und der Steuer- und Auswerteeinheit 4. Beim Messwertgeber 2 sind neben dem Sensor 5 die Elektronikeinheit 6 und der Mikroprozessor 21 dargestellt. Darüber hinaus ist noch angedeutet, dass der Messwertgeber 2 ein Anzeigedisplay 31 aufweist, über das auch vor Ort der gemessene Messwert angezeigt werden kann. Die weiteren, zuvor beschriebenen wesentlichen elektronischen Bauteile des Messwertgebers 2, wie die Stromquelle 7, der Komparator 15 und der Mischer 23 sind in dem vereinfachten Schaltbild gemäß Fig. 2 dargestellt.

Entsprechend sind auch bei der Steuer- und Auswerteeinheit 4 einzelne elektronische Bauelemente nur in Fig. 2 und nicht auch in Fig. 1 dargestellt. In dem Blockschaltbild gemäß Fig. 1 ist dagegen der, in Fig. 2 nicht dargestellte, Mikroprozessor 11 angedeutet, mit dem sowohl der Schalter 13 geschaltet als auch das über den Komparator 24 und den Schmitt-Trigger 25 empfangene serielle Datensignal ausgewertet wird. Darüber hinaus weist die Steuer- und Auswerteeinheit 4 noch ein Anzeigedisplay 32 und mehrere Bedientasten 33 auf, mit denen die einzelnen Messwerte der einzelnen Messwertgeber 2 ausgewählt werden können.

Ist die Steuer- und Auswerteeinheit 4 zum Anschluss mehrerer Messwertgeber 2 ausgebildet, so wie dies in Fig. 1 angedeutet ist, so ist die in Fig. 2 dargestellte Schaltung mit der Last 10, dem weiteren Widerstand 12 und dem Schalter 13 entsprechend für jeden Signaleingang 9 vorgesehen. Auch der Komparator 24 kann entsprechend für jeden Signaleingang 9 vorgesehen sein. Alternativ dazu kann jedoch auch nur ein Komparator vorgesehen sein, der über einen entsprechenden Schalter wahlweise mit jeweils einem Signaleingang 9 bzw. einem Verbindungspunkt 27 verbunden werden kann.

## Patentansprüche

1. Steuer- und Auswerteeinheit (4) für ein Signalübertragungssystem (1), mit einer Last (10), die mit einem Signaleingang (9) verbunden ist, und mit einem Mikroprozessor (11), der eine über der Last (10) abfallende Spannung oder einen durch die Last (10) fließenden Strom erfasst und auswertet, wobei der Last (10) mindestens ein elektrisches Bauteil (12) in Reihe geschaltet ist, an dem ein Gleichspannungsabfall auftritt, wenn das elektrische Bauteil (12) von einem Strom durchflossen wird, wobei das mindestens eine elektrische Bauteil mittels eines Schalters (13) wahlweise überbrückbar ist, **dadurch gekennzeichnet, dass** der Mikroprozessor (11) dazu eingerichtet ist, die Spannung, die über der Last (10) abfällt, oder den Strom, der durch die Last (10) fließt, wenn das elektrische Bauteil (12) überbrückt ist, mit der Spannung, die über der Last (10) abfällt, oder den Strom, der durch die Last (10) fließt, wenn das elektrische Bauteil (12) der Last (10) in Reihe geschaltet ist, zu vergleichen und bei Über- oder Unterschreiten eines Schwellwertes durch einen in dem Vergleich ermittelten Unterschieds der Spannungen bzw. der Ströme einen Fehler zu erkennen.

2. Steuer- und Auswerteeinheit (4) nach Anspruch 1, **dadurch gekennzeichnet, dass** der Schalter (13) vom Mikroprozessor (11) gesteuert ist und das Schalten des Schalters (13) getaktet erfolgt, wobei der Takt einen vorgegebenen seriellen Datenstrom repräsentiert.

3. Steuer- und Auswerteeinheit (4) nach Anspruch 1 oder 2, **dadurch gekennzeichnet, dass** ein Komparator (24) und vorzugsweise ein dem Komparator (24) nachgeschalteter Schmitt-Trigger (25) vorgesehen sind, dass ein Eingang (26) des Komparators (24) mit einem Verbindungspunkt (27) zwischen der Last (10) und dem mindestens einen elektrischen Bauteil (12) verbunden ist und der Mikroprozessor (11) mit dem Ausgang (30) des Komparator (24) oder dem Ausgang des Schmitt-Triggers (25) verbunden ist.

4. Signalübertragungssystem (1) mit mindestens einem Signalwertgeber (2), einer Leitung (3) und einer Steuer- und Auswerteeinheit (4) nach Anspruch 1, wobei der Signalwertgeber (2) eine Elektronikeinheit (6) und eine Stromquelle (7) aufweist, und
wobei der Signalwertgeber (2) dazu eingerichtet ist, einen eingeprägten Strom im Bereich zwischen einem vorbestimmten ersten Wert und einem vorbestimmten zweiten Wert, insbesondere zwischen 4 und 20 mA, in die Leitung (3) einzuspeisen

5. Signalübertragungssystem (1) nach Anspruch 4, **dadurch gekennzeichnet, dass** der Signalwertgeber (2) als Messwertgeber ausgebildet ist und zusätzlich mindestens einen Sensor (5) zur Erfassung eines Messwertes aufweist, wobei der in die Leitung (3) eingespeiste Strom zum erfassten Messwert proportional ist.

6. Signalübertragungssystem (1) nach Anspruch 4 oder 5, **dadurch gekennzeichnet, dass** das elektrische Bauteil (12) als Widerstand, als Diode oder als Reihenschaltung eines Widerstands und einer Diode ausgebildet ist.

7. Signalübertragungssystem (1) nach einem der Ansprüche 4 bis 6, **dadurch gekennzeichnet, dass** das Schalten des Schalters (13) in der Steuer- und Auswerteeinheit (4) getaktet erfolgt, wobei der Takt einen vorgegebenen seriellen Datenstrom repräsentiert.

8. Signalübertragungssystem (1) nach Anspruch 7, **dadurch gekennzeichnet, dass** der Signalwertgeber (2) einen Komparator (15) aufweist, wobei ein Eingang (17) des Komparators (15) mit der Leitung (3) verbunden ist, sodass aus der an der Leitung (3) anstehenden Spannungsänderung, die durch das getaktete Schalten des Schalters (13) in der Steuer- und Auswerteeinheit (4) verursacht wird, ein serieller Datenstrom erfasst wird.

9. Signalübertragungssystem (1) nach Anspruch 8, **dadurch gekennzeichnet, dass** der Signalwertgeber (2) einen Mikroprozessor (21) aufweist, der mit dem Ausgang (20) des Komparators (15) oder dem Ausgang (22) eines dem Komparator (15) nachgeschalteten Schmitt-Triggers (16) verbunden ist.

10. Signalübertragungssystem (1) nach einem der Ansprüche 4 bis 9, **dadurch gekennzeichnet, dass** der Signalwertgeber (2) einen Mischer (23) aufweist, mittels dem dem eingeprägten Strom ein getaktetes Signal überlagert wird, das einen seriellen Datenstrom repräsentiert, sodass in die Leitung (3) ein modulierter Strom eingespeist wird.

11. Signalübertragungssystem (1) nach Anspruch 10, **dadurch gekennzeichnet, dass** die Steuer- und Auswerteeinheit (4) einen Komparator (24) aufweist, wobei ein Eingang (26) des Komparators (24) mit einem Verbindungspunkt (27) zwischen der Last (10) und dem mindestens einen elektrischen Bauteil (12) verbunden ist, sodass aus der aufgrund des modulierten Stroms auftretenden Spannungsänderung über der Last (10) ein serieller Datenstrom erfasst wird.

12. Signalübertragungssystem (1) nach Anspruch 11, **dadurch gekennzeichnet, dass** der Mikroprozessor (11) der Steuer- und Auswerteeinheit (4) mit dem Ausgang (30) des Komparators (24) oder dem Ausgang eines dem Komparator (24) nachgeschalteten Schmitt-Triggers (25) verbunden ist.

## Claims

1. Control and evaluation unit (4) for a signal transmission system (1), having a load (10) which is connected to a signal input (9), and having a microprocessor (11) which detects and evaluates a voltage dropping across the load (10) or a current flowing through the load (10),
wherein at least one electrical component (12) is connected in series with the load (10) at which electrical component a direct voltage drop occurs when a current flows through the electrical component (12), wherein the at least one electrical component can be selectively bypassed by means of a switch (13),
**characterized in**
**that** the microprocessor (11) is configured to compare the voltage which drops across the load (10) or the current which flows through the load (10) when the electrical component (12) is bypassed with the voltage which drops across the load (10) or the current which flows through the load (10) when the electrical component (12) is connected in series with the load (10) and,
if a threshold value is exceeded or fallen below, to detect an error by means of a difference in the voltages or currents determined in the comparison.

2. Control and evaluation unit (4) according to claim 1, **characterized in that** the switch (13) is controlled by the microprocessor (11) and that the switching of the switch (13) is carried out in a clocked manner, wherein the clock represents a preset serial data stream.

3. Control and evaluation unit (4) according to claim 1 or 2, **characterized in that** a comparator (24) and preferably a Schmitt trigger (25) connected downstream of the comparator (24) are provided, that an input (26) of the comparator (24) is connected to a connection point (27) between the load (10) and the at least one electrical component (12) and that the microprocessor (11) is connected to the output (30) of the comparator (24) or the output of the Schmitt trigger (25).

4. Signal transmission system (1) with at least one signal encoder (2), a line (3) and a control and evaluation unit (4) according to claim 1,
wherein the signal encoder (2) comprises an electronic unit (6) and a power source (7), and
wherein the signal encoder (2) is configured to feed an impressed current in the range between a predetermined first value and a predetermined second value, in particular between 4 and 20 mA, into the line (3).

5. Signal transmission system (1) according to claim 4, **characterized in that** the signal encoder (2) is designed as a measured value transmitter and additionally has at least one sensor (5) for capturing a measured value, wherein the current fed into the line (3) is proportional to the detected measured value.

6. Signal transmission system (1) according to claim 4 or 5, **characterized in that** the electrical component (12) is designed as a resistor, as a diode or as a series connection of a resistor and a diode.

7. Signal transmission system (1) according to any one of claims 4 to 6, **characterized in that** the switching of the switch (13) in the control and evaluation unit (4) takes place in a clocked manner, wherein the clock represents a predetermined serial data stream.

8. Signal transmission system (1) according to claim 7, **characterized in that** the signal encoder (2) has a comparator (15), wherein an input (17) of the comparator (15) is connected to the line (3), so that a serial data stream is detected from the voltage change present on the line (3), which is caused by the clocked switching of the switch (13) in the control and evaluation unit (4).

9. Signal transmission system (1) according to claim 8, **characterized in that** the signal encoder (2) has a microprocessor (21) which is connected to the output (20) of the comparator (15) or to the output (22) of a Schmitt trigger (16) connected downstream of the comparator (15).

10. Signal transmission system (1) according to any one of claims 4 to 9, **characterized in that** the signal encoder (2) has a mixer (23) by means of which a clocked signal representing a serial data stream is superimposed on the impressed current, so that a modulated current is fed into the line (3).

11. Signal transmission system (1) according to claim 10, **characterized in that** the control and evaluation unit (4) has a comparator (24), wherein an input (26) of the comparator (24) is connected to a connection point (27) between the load (10) and the at least one electrical component (12), so that a serial data stream is detected from the voltage change occurring across the load (10) due to the modulated current.

12. Signal transmission system (1) according to claim 11, **characterized in that** the microprocessor (11) of the control and evaluation unit (4) is connected to the output (30) of the comparator (24) or to the output of a Schmitt trigger (25) connected downstream of the comparator (24).

## Revendications

1. Unité de commande et d'interprétation (4) pour un système de transmission de signaux (1), comprenant une charge (10) qui est reliée à une entrée de signal (9), et comprenant un microprocesseur (11) qui détecte et interprète une tension qui chute aux bornes de la charge (10) ou un courant qui circule à travers la charge (10),
au moins un composant électrique (12) étant branché en série avec la charge (10), aux bornes duquel se produit une chute de tension continue lorsque le composant électrique (12) est traversé par un courant, l'au moins un composant électrique pouvant être court-circuit sélectivement au moyen d'un commutateur (13),
**caractérisée en ce**
**que** le microprocesseur (11) est conçu pour comparer la tension qui chute aux bornes de la charge (10) ou le courant qui circule à travers la charge lorsque le composant électrique (12) est court-circuité, avec la tension qui chute aux bornes de la charge (10) ou le courant qui circule à travers la charge lorsque le composant électrique (12) est branché en série avec la charge (10) et
pour reconnaître un défaut dans le cas où une différence entre les tensions ou les courants déterminée par la comparaison devient supérieure ou inférieure à une valeur de seuil.

2. Unité de commande et d'interprétation (4) selon la revendication 1, **caractérisée en ce que** le commutateur (13) est commandé par le microprocesseur (11) et la commutation du commutateur (13) s'effectue de manière cadencée, la cadence d'horloge représentant un flux de données série prédéfini.

3. Unité de commande et d'interprétation (4) selon la revendication 1 ou 2, **caractérisée en ce qu'**un comparateur (24) et de préférence un trigger de Schmitt (25), branché en aval du comparateur (24), sont présents, **en ce qu'**une entrée (26) du comparateur (24) est reliée à un point de connexion (27) entre la charge (10) et l'au moins un composant électrique (12) et le microprocesseur (11) est relié à la sortie (30) du comparateur (24) ou à la sortie du trigger de Schmitt (25).

4. Système de transmission de signal (1) comprenant au moins un transmetteur de valeur de signal (2), une ligne (3) et une unité de commande et d'interprétation (4) selon la revendication 1, le transmetteur de valeur de signal (2) possédant une unité électronique (6) et une source de courant (7), et le transmetteur de valeur de signal (2) étant configuré pour injecter un courant incrusté entre une première valeur prédéterminée et une deuxième valeur prédéterminée, notamment entre 4 et 20 mA, dans la ligne (3).

5. Système de transmission de signal (1) selon la revendication 4, **caractérisé en ce que** le transmetteur de valeur de signal (2) est réalisé sous la forme d'un transmetteur de valeur mesurée et possède en plus au moins un capteur (5) destiné à acquérir une valeur mesurée, le courant injecté dans la ligne (3) étant proportionnel à la valeur mesurée acquise.

6. Système de transmission de signal (1) selon la revendication 4 ou 5, **caractérisé en ce que** le composant électrique (12) est réalisé sous la forme d'une résistance, d'une diode ou d'un circuit série composé d'une résistance et d'une diode.

7. Système de transmission de signal (1) selon l'une des revendications 4 à 6, **caractérisé en ce que** la commutation du commutateur (13) dans l'unité de commande et d'interprétation (4) s'effectue de manière cadencée, la cadence d'horloge représentant un courant de données série prédéfini.

8. Système de transmission de signal (1) selon la revendication 7, **caractérisé en ce que** le transmetteur de valeur de signal (2) possède un comparateur (15), une entrée (17) du comparateur (15) étant reliée à la ligne (3), de sorte qu'un courant de données série est détecté à partir de la variation de tension qui se produit au niveau de la ligne (3), laquelle est causée par la commutation cadencée du commutateur (13) dans l'unité de commande et d'interprétation (4).

9. Système de transmission de signal (1) selon la revendication 8, **caractérisé en ce que** le transmetteur de valeur de signal (2) possède un microprocesseur (21), lequel est relié à la sortie (20) du comparateur (15) ou à la sortie (22) d'un trigger de Schmitt (16) branché en aval du comparateur (15).

10. Système de transmission de signal (1) selon l'une des revendications 4 à 9, **caractérisé en ce que** le transmetteur de valeur de signal (2) possède un mélangeur (23) au moyen duquel un signal cadencé, qui représente un courant de données série, est superposé au courant incrusté, de sorte qu'un courant modulé est injecté dans la ligne (3).

11. Système de transmission de signal (1) selon la revendication 10, **caractérisé en ce que** l'unité de commande et d'interprétation (4) possède un comparateur (24), une entrée (26) du comparateur (24) étant reliée à un point de connexion (27) entre la charge (10) et l'au moins un composant électrique (12), de sorte qu'un courant de données série est détecté à partir de la variation de tension aux bornes de la charge (10) qui se produit en raison du courant modulé.

12. Système de transmission de signal (1) selon la revendication 11, **caractérisé en ce que** le microprocesseur (11) de l'unité de commande et d'interprétation (4) est relié à la sortie (30) du comparateur (24) ou la sortie d'un trigger de Schmitt (25) branché en aval du comparateur (24).
